Europäisches Patentamt

(19) European Patent Office

Office européen des brevets

(11) **EP 1 178 321 B1**

(12) **EUROPÄISCHE PATENTSCHRIFT**

(45) Veröffentlichungstag und Bekanntmachung des Hinweises auf die Patenterteilung:
**01.12.2004 Patentblatt 2004/49**

(51) Int Cl.$^7$: **G01R 31/3181**, G01R 31/3185

(21) Anmeldenummer: **01117701.1**

(22) Anmeldetag: **26.07.2001**

(54) **Verfahren zum Betreiben eines Logik- und Speicherelemente aufweisenden Bausteins**

Method of operating a component having a logic and a memory portion

Procédé d'exploitation d'un composant comportant une partie logique et une partie mémoire

(84) Benannte Vertragsstaaten:
**AT CH DE ES FR GB LI**

(30) Priorität: **03.08.2000 DE 10037992**

(43) Veröffentlichungstag der Anmeldung:
**06.02.2002 Patentblatt 2002/06**

(73) Patentinhaber: **SIEMENS AKTIENGESELLSCHAFT**
**80333 München (DE)**

(72) Erfinder:
- **Krueger, Richard**
  **85053 Ingolstadt (DE)**
- **Mayer, Frank**
  **91080 Erlangen (DE)**
- **Merchant, Kamal**
  **91058 Erlangen (DE)**

(56) Entgegenhaltungen:
DE-A- 19 805 819         US-A- 4 412 327
US-A- 5 673 274         US-A- 5 958 072

**Beschreibung**

Die Erfindung geht aus von einem Verfahren zum Betreiben eines Logik- und Speicherelemente aufweisenden Bausteins oder einer Logik- und Speicherelemente aufweisenden Baugruppe, wobei der Baustein oder die Baugruppe in verschiedenen Betriebsarten betreibbar ist, von denen eine der Normalbetrieb und eine weitere ein Testbetrieb ist.

Weiterhin betrifft die Erfindung einen in verschiedenen Betriebsarten betreibbaren Baustein.

Aus der DE 198 05 819 A1 ist bereits ein Verfahren zur Überwachung von integrierten Schaltkreisen bzw. ASICs in sicherheitskritischen Anwendungen bekannt. Bei diesem Verfahren werden zwei ASICs mit identischem Aufbau parallel und zeitgleich an alle Eingänge angeschlossen. Sie arbeiten streng synchron zueinander und überwachen sich gegenseitig. Sie führen einen Vergleich von Zwischenergebnissen, Endergebnissen und Ausgangsdaten durch. Der logische Zustand in verschiedenen Überwachungspunkten, der beliebigen internen Schaltzuständen und internen Signalen zu diskreten Abtastzeitpunkten entspricht, wird überwacht.

Weiterhin offenbart die DE 198 05 819 A1, in einen ASIC einen Test-Controller zu integrieren. Dieser Test-Controller liest den Inhalt eines Testmusterspeichers aus und steuert einen Einschalt-Selbsttest des ASICs, den zyklischen Vergleich bausteininterner Werte während des Betriebes sowie den Systemtakt und den Scan-Takt des Bausteins. Weiterhin kann auf die beschriebene Weise auch ein externer Test des einen ASICs durch den Test-Controller des anderen ASICs erfolgen.

Ausgehend von diesem Stand der Technik liegt der Erfindung die Aufgabe zugrunde, den Testbetrieb zu verbessern.

Diese Aufgabe wird durch ein Verfahren mit den im Anspruch 1 angegebenen Merkmalen gelöst. Vorteilhafte Weiterbildungen ergeben sich aus den abhängigen Ansprüchen 2-12. Die Ansprüche 13-22 betreffen einen in verschiedenen Betriebsarten betreibbaren Baustein.

Die Vorteile der Erfindung bestehen insbesondere darin, dass es ermöglicht wird, den Baustein-Selbsttest auch im Sinne eines Online-Betriebes durchzuführen. Dies ist insbesondere in unterbrechungsfrei laufenden sicherheitskritischen Anwendungen von Bedeutung.

Die Erfindung erlaubt im Gegensatz zum Gegenstand der DE 19805819 A1 nicht nur einen einmaligen Einschalt-Selbsttest, sondern ermöglicht einen wiederkehrenden Test im Betrieb, wobei das umgebende System während des Tests nicht beeinflusst wird, da der Test nicht nach außen wirkt, und der ursprüngliche Betriebszustand eines getesteten Blocks nach Abschluß des Tests wiederhergestellt wird.

Normalbetrieb und Testbetrieb wechseln in der Regel einander ab. Der Normalbetrieb wird vom Testbetrieb nicht beeinflusst. Somit wird ein Dauerbetrieb des Bausteins bzw. der Baugruppe mit ständiger Selbstüberwachung ermöglicht. Dies entspricht einem Online-Test, der einen Strukturtest durch Signaturvergleich sowie einen Informationsvergleich aufweist.

Zur Realisierung des Testbetriebs wird die Funktion des Bausteins in eine oder mehrere unabhängige und unabhängig testbare Testgruppen partitioniert, mit beispielsweise je 10 Flip-Flops als Zustandsspeicher und der zugehörigen kombinatorischen Logik. Bei einer Testgruppe kann es sich beispielsweise um eine einzelne FSM (Finite State Machine) handeln.

Durch die beanspruchte Aufteilung der Betriebszeit in Zeitschlitze kann ein Online-Selbsttest während vorgegebener Zeitschlitze erfolgen, wenn dafür gesorgt wird, dass während der für die Durchführung des Online-Selbsttests vorgesehenen Zeitschlitze keine Veränderungen der Ausgangszustände der Testgruppen und damit auch des gesamten Bausteins erfolgen.

Die zur Durchführung des Online-Selbsttests notwendigen Referenz- bzw. Vergleichswerte werden gemäß einer ersten Ausführungsform der Erfindung von einem baugleichen, parallel angeordneten weiteren Baustein gewonnen, der mit denselben Testvektoren beaufschlagt wird.

Gemäß einer weiteren Ausführungsform der Erfindung werden diese Vergleichs- bzw. Referenzwerte von einem internen Speicher abgeleitet, der bereits bei der Herstellung des Bausteins oder am Einsatzort vom Anwender mit den Referenzwerten geladen wird. Bei dieser Ausführungsform ist ein zweiter, parallel angeordneter baugleicher Baustein nicht notwendig.

Die Erfindung ist sowohl anwendbar beim Vorliegen einkanaliger als auch beim Vorliegen mehrkanaliger Architekturen. Unter einem Kanal versteht man dabei ein Element oder eine Gruppe von Elementen, die unabhängig voneinander jeweils eine Funktion ausführen.

Weitere Vorteile und Einzelheiten der Erfindung ergeben sich aus der Erläuterung von Ausführungsbeispielen anhand der Figuren. Es zeigt

Figur 1 ein Blockschaltbild eines Ausführungsbeispiels für die zusätzliche Testlogik einer Testgruppe,

Figur 2 ein Blockschaltbild einer aus drei Speicherelementen bestehenden Speicherkette,

Figur 3 ein Blockschaltbild eines Ausführungsbeispiels für die Ausgangslogik einer Testgruppe,

Figur 4 ein Blockschaltbild eines ersten Ausführungsbeispiels für die Eingangslogik eines Speicherelementes einer Testgruppe,

Figur 5 ein Blockschaltbild eines zweiten Ausführungsbeispiels für die Eingangslogik eines Speicherelementes einer Testgruppe und

Figur 6 ein Blockschaltbild eines dritten Ausführungsbeispiels für die Eingangslogik eines Speicherelementes einer Testgruppe.

In sicherheitskritischen Anwendungen kommen oftmals ASICs zur Anwendung, bei denen es sich um Bausteine handelt, die eine Vielzahl von Logik- und Speicherelementen aufweisen. Da es bei derartigen Anwendungen von hoher Bedeutung ist, auftretende Fehler, beispielsweise sogenannte Stuck-at-Fehler bzw. Haftfehler, bei welchen interne bzw. Ausgangszustände bzw. Signale in einem Zustand haften, schnell zu erkennen, ist es notwendig, regelmäßig einen Baustein-Selbsttest durchzuführen, um die korrekte Arbeitsweise der Testgruppe und des gesamten Bausteins zu überprüfen.

Dieser Baustein-Selbsttest erfolgt erfindungsgemäß ohne eine Unterbrechung des laufenden Baustein/Baugruppenbetriebes. Um während des laufenden Baustein/Baugruppenbetriebes einen Baustein/Baugruppen-Selbsttest durchführen zu können, wird die Betriebszeit des Bausteins in eine Vielzahl von Zeitschlitzen unterteilt, die vorzugsweise unterschiedliche Zeitdauern aufweisen. Während der längeren Zeitschlitze, die dem überwiegenden Teil der Betriebszeit entsprechen, arbeitet der Baustein beispielsweise im Normalbetrieb. Während der kurzen Zeitschlitze, die beispielsweise einem Prozent oder weniger der gesamten Betriebszeit des Bausteins entsprechen, erfolgt beispielsweise die Durchführung des Baustein-Selbsttests. Während dieses Baustein-Selbsttests wird dafür Sorge getragen, dass sich der Ausgangszustand der jeweiligen Testgruppe nicht verändert. Dies bedeutet, dass die zu Beginn eines Selbsttestvorganges vorliegenden Ausgangszustände der Logik- und Speicherelemente des Bausteins erhalten bleiben. Die durch den Selbsttest veränderten internen Zustände der Testgruppe werden am Ende der Testphase aus den zwischengespeicherten Zuständen wiederhergestellt.

Zur Durchführung eines derartigen Baustein-Selbsttests wird jeder Testgruppe eine zusätzliche Testlogik zugeordnet. Diese Testlogik enthält eine Eingangslogik und eine Ausgangslogik. Mittels der Eingangslogik wird sichergestellt, dass während des Selbsttests die notwendigen Eingangssignale an die Logik- bzw. Speicherelemente gelangen. Die Ausgangslogik sorgt dafür, dass sich während des Selbsttests der Ausgangszustand der jeweiligen Testgruppe nicht verändert. Unter bestimmten Voraussetzungen kann sogar eine Veränderung der Ausgangszustände der jeweiligen Testgruppen erlaubt werden, wenn sichergestellt ist, dass das Gesamtsystem hiervon nicht beeinflusst wird.

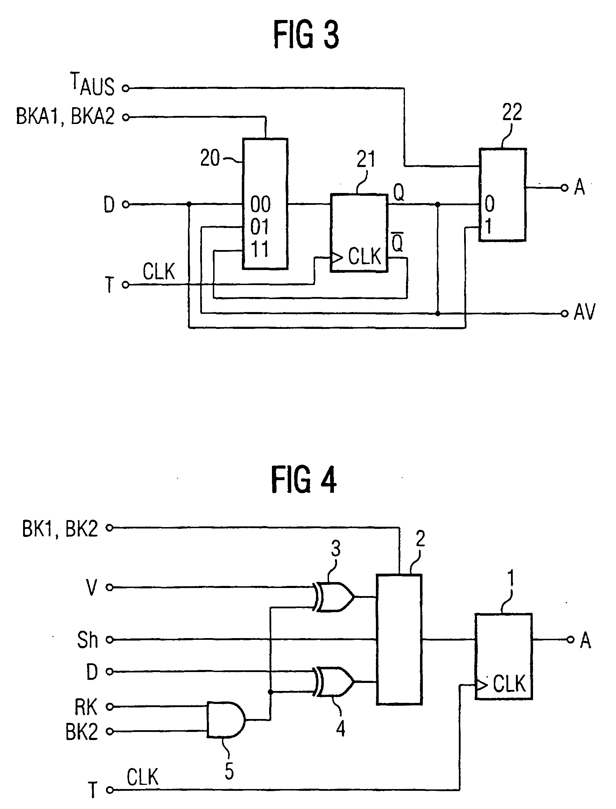

Die Figur 4 zeigt ein Blockschaltbild eines ersten Ausführungsbeispiels für die Eingangslogik eines Speicherelementes einer Testgruppe. In der Figur 4 ist ein beispielsweise als D-Flip-Flop 1 realisiertes Speicherelement dargestellt, welches einen Dateneingang und einen Takteingang sowie einen Datenausgang A aufweist. Das am Takteingang anliegende Taktsignal CLK wird an einem Eingang T bereitgestellt.

Dem Dateneingang des D-Flip-Flops 1 ist eine Eingangslogik vorgeschaltet, die eine Vielzahl von Eingangsanschlüssen BK1, V, Sh, D, RK und BK2 sowie einen Multiplexer 2, XOR-Glieder 3, 4 und ein UND-Glied 5 aufweist.

Am Eingangsanschluss BK1/BK2 liegen während des Betriebes des Bausteins Betriebsartkennsignale in Form von vorzugsweise 2-Bit-breiter Steuerinformation an, welche in einer nicht gezeichneten Steuereinheit erzeugt wird. Die gezeigte Vorrichtung ist vorzugsweise in vier verschiedenen Betriebsarten betreibbar. Zu diesen Betriebsarten gehören der Normalbetrieb, ein Schiebemodus, ein Signaturbildungsmodus und ein Verdrahtungstestmodus. Beispielsweise kennzeichnet die Bitfolge 00 den Normalbetrieb, die Bitfolge 10 den Schiebemodus, die Bitfolge 11 den Signaturbildungsmodus und die Bitfolge 01 den Verdrahtungstestmodus

Im Normalbetrieb arbeitet die gezeigte Vorrichtung wie ein gewöhnliches D-Flip-Flop. Dabei gelangt das am Eingang D anliegende Eingangssignal der Vorrichtung über das XOR-Glied 4 und den Multiplexer 2 an den Dateneingang des D-Flip-Flops 1. Für die an den Eingangsanschlüssen V, Sh und RK anliegenden Signale bildet die Eingangslogik mit dem Multiplexer 2 eine Sperre.

Der Schiebemodus, der Signaturbildungsmodus und der Verdrahtungstestmodus bilden insgesamt den Testbetrieb, welcher während des laufenden Bausteinbetriebes in Zeitschlitzen vorgenommen wird. Im Schiebemodus sind beispielsweise mehrere hintereinander angeordnete D-Flip-Flops zur Realisierung eines Schieberegisters zusammengeschaltet. Beispielsweise wird dabei dem in Figur 4 gezeigten Eingang Sh ein Signal von einem benachbarten Speicherelement derselben Testgruppe zugeführt und über den Multiplexer 2 an den Dateneingang des D-Flip-Flops 1 weitergeleitet. In diesem Modus ist beispielsweise ein Auslesen bzw. Sichern einer Signatur und die gleichzeitige Rückgewinnung des aktuellen Zustands einer Testgruppe oder die Sicherung des aktuellen Zustands einer Testgruppe vor dem Beginn eines Online-Selbsttests möglich. Unter Signatur bzw. Signaturbildung versteht man bei der Erfindung die Anwendung von Testvektoren auf eine Logikstruktur und die anschließende Ableitung eines Prüfmusters aus den Ausgangsvektoren der Logikstruktur.

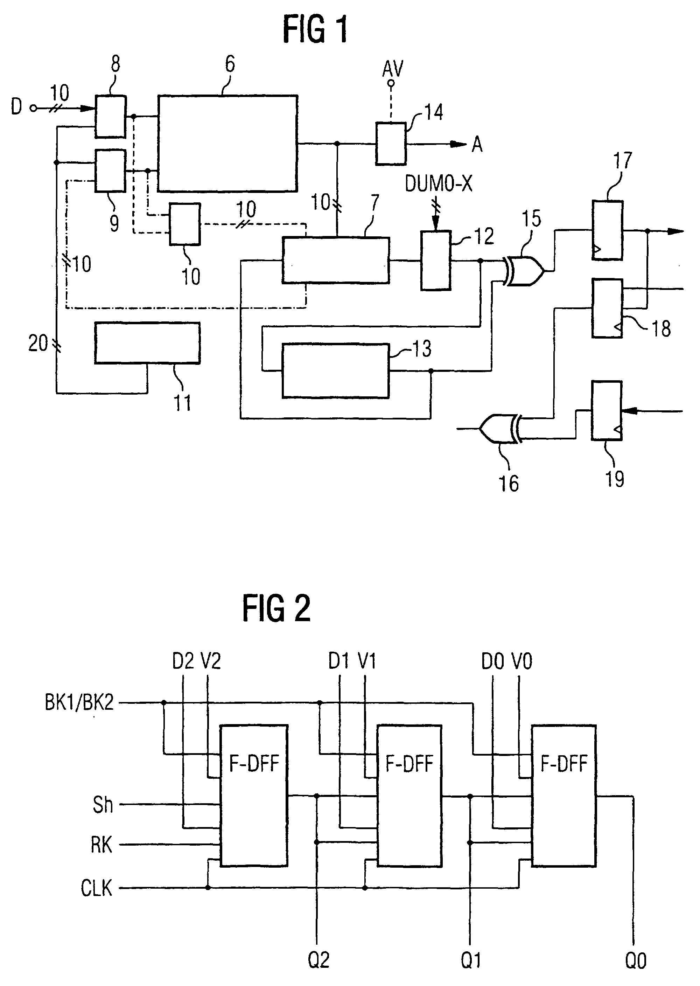

Im Signaturbildungsmodus werden n-Bit breite Testvektoren an die Eingänge V0-VN und D0-DN (siehe FIG 2) angelegt. Durch die gewählte Verdrahtung und eine geeignete Ansteuerung, wie sie noch unten unter Bezugnahme auf die Figur 1 erläutert wird, kann in diesem Modus eine Signaturbildung erfolgen.

Im Verdrahtungstestmodus werden die Verdrahtungen zwischen einzelnen Testgruppen und die Rückkopplungen der Speicherelemente der Testgruppe in eine kombinatorische Logik getestet, wie ebenfalls unten unter Bezugnahme auf die Figur 1 noch erläutert wird. In diesem Modus werden dem Eingang V (siehe Figur 4) ein Signal von einer benachbarten Testgruppe (siehe Ausgang AV vom Block 14 in Figur 1) und dem Eingang RK (siehe Figur 4) Rückkopplungsinformationen zugeführt. Der Eingang BK2 ist ein Eingang für ein Betriebsartkennsignal, nämlich für das zweite Bit der oben angegebenen 2-Bit breiten Steuerinformation.

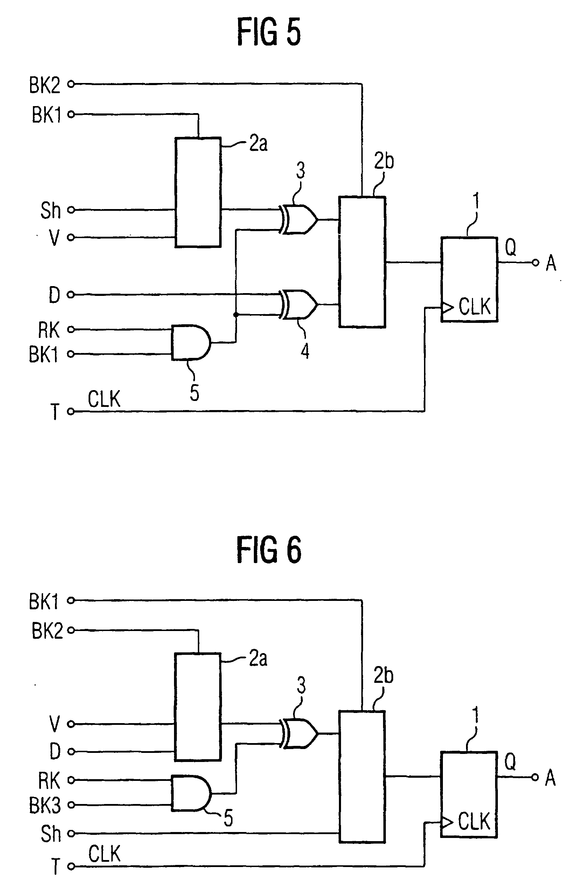

Mittels der vorstehend beschriebenen Eingangslogik wird nach alledem sichergestellt, dass während der verschiedenen Betriebsarten, die im Zeitmultiplexbetrieb ablaufen, jeweils gewünschte Eingangssignale an den Dateneingang des D-Flip-Flops 1 gelangen. In der Figur 4 ist beispielsweise eine Vorrichtung abgebildet, die nachfolgend stets als fehlersicheres D-Flip-Flop bzw. F-DFF bezeichnet wird. Die Figuren 5 und 6 zeigen weitere Realisierungsmöglichkeiten für ein fehlersicheres Flip-Flop F-DFF.

Während des beschriebenen Selbsttestbetriebes, der ohne Unterbrechung des Bausteinbetriebes erfolgt, wird dafür gesorgt, dass sich die Ausgangszustände aller Testgruppen und damit auch der Ausgang des Bausteins nicht verändern. Zu diesem Zweck wird - wie aus der Figur 1 hervorgeht - an den Datenausgang jeder Testgruppe eine Ausgangslogik 14 angeschlossen, welche Zustandshaltemittel aufweist, mittels derer eine Veränderung des Ausgangszustands der Testgruppe während des Selbsttestbetriebes verhindert wird.

Ein Ausführungsbeispiel für den Aufbau einer derartigen Ausgangslogik ist in der Figur 3 gezeigt. Diese weist beispielsweise einen ersten Multiplexer 20, ein D-Flip-Flop 21 und einen zweiten Multiplexer 22 auf. Dem ersten Multiplexer 20 wird als Steuersignal eine am Eingang BKA1/BKA2 anliegende 2-Bit-breite Steuerinformation zugeführt. An den drei Dateneingängen dieses Multiplexers 20 liegen das Ausgangssignal D der vorliegenden Testgruppe, das Ausgangssignal Q des Flip-Flops 21 und das Ausgangssignal $\overline{Q}$ des Flip-Flops 21 an. Zwischen diesen Signalen wird in Abhängigkeit von Betriebsartkennsignalen umgeschaltet.

Der Ausgang des Multiplexers 20 ist mit dem D-Eingang des Flip-Flops 21 verbunden. Weiterhin wird dem Flip-Flop 21 das am Eingang T anliegende Taktsignal CLK zugeführt.

Das Ausgangssignal Q des Flip-Flops 21 wird an einen ersten Dateneingang des Multiplexers 22 und an den zweiten Dateneingang des Multiplexers 20 angelegt. Das Ausgangssignal $\overline{Q}$ des Flip-Flop 21 wird an den dritten Dateneingang des Multiplexers 20 zurückgekoppelt.

Dem zweiten Dateneingang des Multiplexers 22 wird das am Eingang D der Vorrichtung anliegende Datensignal zugeführt, welches dem Ausgangssignal der vorliegenden Testgruppe entspricht. Als Steuersignal für den Multiplexer 22 dient ein am Eingang $T_{AUS}$ anliegendes Signal. Die Betriebsartkennsignale BKA1, BKA2 und $T_{AUS}$ werden in der nicht gezeichneten Steuereinheit generiert.

Während des Testbetriebes übernimmt das Sonder-Flip-Flop 14 von Figur 1 beispielsweise zwei Funktionen:

- ein Einfrieren der primären Ausgänge der Testgruppe und
- einen Test von von der Testgruppe an andere Testgruppen gehenden Verdrahtungen.

Während des Testbetriebes einer Testgruppe wird der primäre Ausgang A der Testgruppe eingefroren. Dies kann am einfachsten dadurch erreicht werden, wenn der Takt CLK des Sonder-Flip-Flops 14 der im Test befindlichen Testgruppe während des gesamten Testbetriebes abgeschaltet wird und der Multiplexer 22 so gesteuert wird, dass der obere Eingang durchgeschaltet wird. Alternativ dazu kann der Multiplexer 20 so gesteuert werden, dass sein mittlerer Eingang durchgeschaltet wird. In diesem Fall bleibt der Ausgang des Flip-Flops 21 unverändert. Der Multiplexer 22 wird in ähnlicher Weise gesteuert wie im ersten Fall.

Für den Verdrahtungstest werden alle weiteren Testgruppen - außer der im Test befindlichen Testgruppe - sequentiell abgefragt. Hierbei werden alle Sonder-Flip-Flops der weiteren Testgruppen, deren Verdrahtung (Signale AV) jeweils getestet wird, zweimal getoggelt. Vor Beginn des Verdrahtungstests wird der Multiplexer 20 des Sonder-Flip-Flops dieser weiteren Testgruppe umgeschaltet, so dass der untere Eingang des Multiplexers durchgeschaltet ist. Vor dem zweimaligen Toggeln, d.h. dem zweimaligen Invertieren zur Wiederherstellung des ursprünglichen Zustandes, des Flip-Flops 21 wird der Multiplexer 22 umgeschaltet, so dass der untere Eingang des Multiplexers durchgeschaltet ist. Anschließend wird der ursprüngliche Zustand wiederhergestellt. Während des zweimaligen Toggelns wird die Signatur der Verdrahtungssignale in der momentan getesteten Testgruppe gebildet, welche Signatur zu einem späteren Zeitpunkt ausgewertet wird.

Die Figur 1 zeigt ein Blockschaltbild eines Ausführungsbeispiels für die zusätzliche Testlogik einer Testgruppe, wobei die Testgruppe eine kombinatorische Logik 6 und ein fehlersicheres 10-Bit-D-Flip-Flop 7 (10-Bit-F-DFF) im Sinne der Figur 4 aufweist.

Während des Testbetriebes dient ein Testmustergenerator 11 als Quelle für Testvektoren. Dieser Testmustergenerator wird in Abhängigkeit von der Art des durchzuführenden Tests von der nicht gezeichneten Steuereinheit mit den jeweiligen Testvektoren geladen. Der Ausgang des Testmustergenerators 11 ist mit Eingangsanschlüssen zweier Multiplexer 8 und 9 verbunden, beispielsweise über eine 20-Bit-Leitung. Weiterhin ist der Multiplexer 8 eingangsseitig an einen primären Dateneingang D angeschlossen, an welchem bausteinexterne oder von einer anderen Testgruppe abgeleitete Datensignale anliegen. Der Ausgang des Multiplexers 8 ist mit einem Eingang der kombinatorischen Logik 6 verbunden.

Der Multiplexer 9 ist eingangsseitig weiterhin über einen Rückkopplungspfad mit einem Ausgang des 10-Bit-F-DFFs 7 verbunden. Der Ausgang des Multiplexers 9 ist an einen weiteren Eingang der kombinatorischen Logik 6 angeschlossen. Die Ausgänge der Multiplexer 8 und 9 sind weiterhin mit den Eingängen eines weiteren Multiplexers 10 verbunden, dessen Ausgang an das F-DFF 7 angelegt ist. Dort gelangen die Ausgangssignale des Multiplexers 10 an die Eingänge V, die in der Figur 4 beschrieben sind.

Eingangsseitig werden dem F-DFF 7 weiterhin die Ausgangssignale der kombinatorischen Logik 6 und das Ausgangssignal eines Schieberegisters 13 zugeführt. Dabei werden die Ausgangssignale der kombinatorischen Logik 6 den in der Figur 4 gezeigten Eingängen D und das Ausgangssignal des Schieberegisters 13 dem in Figur 4 beschriebenen Schiebeeingang Sh des ersten F-DFFs der Flip-Flop-Kette 7 zugeführt.

Der Ausgang des F-DFFs 7 ist über einen Multiplexer 12 an einen Eingang eines XOR-Gliedes 15 und an den Eingang des Schieberegisters 13 angeschlossen. Über die verbleibenden, nicht gezeichneten Eingänge des Multiplexers 12 können die Ausgänge von Block 7 anderer Testgruppen zugeschaltet werden.

Die Auswahl erfolgt durch ein von der nicht gezeichneten Steuereinheit geliefertes Steuersignal DUM0-X. Der Ausgang des Schieberegisters 13 steht mit einem weiteren Eingang des XOR-Gliedes 15 in Verbindung.

In einer ersten Ausführungsform, bei welcher zwei identische Bausteine verwendet werden, wird der Ausgang des XOR-Gliedes 15 mit einem D-Flip-Flop 17 verbunden, an dessen Ausgang jeweils ein Bit eines Signatursignals zur Verfügung steht. Weiterhin ist der Ausgang des D-Flip-Flops 17 mit dem Eingang eines weiteren D-Flip-Flops 18 verbunden, der weiterhin einen Toggel-Eingang aufweist und dessen Ausgang an einen Eingang eines XOR-Gliedes 16 angelegt ist. Dem zweiten Eingang des XOR-Gliedes 16 wird über ein D-Flip-Flop 19 ein Bit eines beispielsweise von einem Partner-ASIC abgeleiteten Signatursignals zugeführt. Im XOR-Glied 16 erfolgt ein Signaturvergleich. Beim Feststellen eines Fehlers wird der sichere Zustand des Prozesses, in welchem die ASICs eingesetzt sind, herbeigeführt bzw. aufrechterhalten.

Bei einer zweiten Ausführungsform, bei welcher ebenfalls zwei identische Bausteine verwendet werden, entfällt das XOR-Glied 15. Der Ausgang des Multiplexers 12 wird direkt mit dem Eingang des Flip-Flops 17 verbunden.

Bei einer dritten Ausführungsform, bei welcher nur ein Baustein vorgesehen ist und bei welcher Referenzsignaturen verwendet werden, entfällt das Flip-Flop 17. Der Ausgang des XOR-Gliedes 15 wird direkt auf den Eingang des Flip-Flops 18 geführt. Das Flip-Flop 19 kann entfallen, wenn keine Einsynchronisation erforderlich ist. Die Referenzsignatur wird dann direkt auf den unteren Eingang des XOR-Gliedes 16 geführt. Der Schaltungsblock 18 kann in verschiedener Weise ausgeführt sein. Wesentlich ist nur, dass für den auch durchzuführenden Test des XOR-Gliedes 16 das vom XOR-Glied 15 gelieferte Signal im Schaltungsblock 18 so verändert werden kann, dass auch ein fehlerhaftes Arbeiten des XOR-Gliedes 16 erkannt werden kann.

Um zu vermeiden, dass während des Selbsttestbetriebes Veränderungen des Ausgangszustands der gezeigten Testgruppe auftreten, ist an den Ausgang der kombinatorischen Logik 6 eine Ausgangslogik 14 angeschlossen, welche Zustandshaltemittel aufweist, mittels derer eine Veränderung der Ausgangszustände der Testgruppe verhindert wird. Ein Beispiel für den Aufbau einer derartigen Ausgangslogik wurde bereits oben im Zusammenhang mit der Figur 3 beschrieben. Der Ausgang A des Blocks 14 ist ein primärer Ausgang und wird nach außen geführt.

Das vorstehend beschriebene Konzept für die Durchführung eines Online-Selbsttests weist eine Reihe von Vorteilen auf:

Vorhandene Flip-Flops können sowohl im Normalbetrieb als auch im Testbetrieb verwendet werden. Sie dienen im Testbetrieb beispielsweise als Schieberegister mit oder ohne lineare Rückkopplung.

Ein Verdrahtungstest kann ebenso wie ein Test der kombinatorischen Logik unter Verwendung einer Signaturbildung durchgeführt werden. Eine Durchführung eines Tests der Verdrahtung zwischen Testgruppen kann in vorteilhafter Weise mit wenigen Zyklen durchgeführt werden.

Die Ausgänge aller Testgruppen werden beim Online-Selbsttest durch Verwendung einer Ausgangslogik eingefroren. Bei der Durchführung eines Verdrahtungstests kann die Ausgangslogik (Block 14) ebenfalls mit getestet werden.

Die Zusatz-Hardware für einen vollständigen Online-Test beschränkt sich bei dem in Figur 1 gezeigten Ausführungsbeispiel auf 30 2:1 Multiplexer (siehe Multiplexer 8, 9 und 10), einen 20-Bit-Testmustergenerator 11, ein 10-Bit-Schieberegister 13 mit vorgeschaltetem 30:1-Multiplexer 12 (bei Verwendung von maximal 30 Testgruppen pro ASIC) und drei D-Flip-Flops 17, 18, 19 zum Weiterleiten von Signatursignalen sowie den Block 14 (2 Multiplexer und ein Flip-Flop pro primärem oder an eine andere Testgruppe gehendem Ausgangssignal). Bis auf die genannten Multiplexer 8, 9, 10 und die Ausgangslogikblöcke 14 kann die Zusatz-Hardware für den Online-Selbsttest von allen Testgruppen eines Bausteins, beispielsweise insgesamt 30 Testgruppen, gemeinsam genutzt werden, wobei diese Testgruppen sequentiell nacheinander getestet werden.

Weiterhin kann der beschriebene Online-Selbsttest an beliebiger Stelle unterbrochen werden. Dies erlaubt eine problemlose Anpassung an verschiedene Systemanforderungen. Werden sehr kurze System-Reaktionszeiten gefordert, dann kann der Online-Selbsttest auch auf verschiedene kurze Zeitschlitze aufgeteilt werden. Dies bedeutet, dass ein vollständiger Online-Selbsttest nicht während eines einzigen Zeitschlitzes erfolgen muss.

Ein weiterer Vorteil der Erfindung besteht darin, dass ein F-DFF im Sinne der Erfindung auch als Scanpath-Flip-Flop zum herkömmlichen Scan-Path-orientierten Produktionstest genutzt werden kann. Dies ist insbesondere für die Hersteller des ASICs von Vorteil.

Gemäß der oben beschriebenen ersten und zweiten Ausführungsform der Erfindung sind parallel zueinander zwei baugleiche ASICs vorgesehen, die völlig synchron zueinander arbeiten und beispielsweise von einem gemeinsamen fehlersicheren Quarz versorgt werden. Die während des Online-Selbsttests gebildete Signatur wird dann bitweise mit einer vom jeweils anderen ASIC gelieferten Referenzsignatur verglichen. Bei Ungleichheit der Signatur wird das System in einen sicheren Zustand gebracht.

Gemäß der oben beschriebenen dritten Ausführungsform der Erfindung ist beispielsweise der die Referenzsignatur enthaltende Referenzspeicher im zu testenden ASIC selbst angeordnet. Ein zweiter ASIC ist bei dieser Ausführungsform nicht notwendig. Der Referenzspeicher kann auch außerhalb des ASICs angeordnet sein.

Ein Test der kombinatorischen Logik kann stufenweise erfolgen und beispielsweise alle drei Sekunden für die Dauer von 0,5 Millisekunden durchgeführt werden. Die Testzeit und das Testintervall können in Abhängigkeit von den jeweiligen Systemanforderungen bestimmt bzw. variiert werden.

Ein Online-Selbsttest umfasst drei Stufen, nämlich einen Test der Rückkopplung der F-DFFs, einen Test der Verdrahtung zwischen den Testgruppen und einen Test der kombinatorischen Logik.

Zum Test der Rückkopplung der F-DFFs wird der 20-Bit-Testmustergenerator 11 von der Steuereinheit mit einem Einsvektor, d. h. mit dem Testvektor "1...1" geladen und das 10-Bit-Schieberegister 13 zurückgesetzt, d. h. mit "0...0" geladen. Dann erfolgt ein Auslesen des momentanen Zustands der Testgruppe in einem Schiebemodus für die Dauer von zehn Taktsignalen. Gleichzeitig erfolgt ein Signaturvergleich und die serielle Übertragung des Nullvektors vom Schieberegister 13 zum F-DFF 7.

Sind dann alle F-DFFs im Nullzustand, dann wird über die Multiplexer 9 und 10 an den V-Eingängen ein Nullvektor zugeschaltet und die Signatur gebildet. Dies entspricht dem ersten Teil eines Rückkopplungstests, wobei dieser unter Verwendung der unteren Eingänge des Multiplexers 9 und der oberen Eingänge des Multiplexers 10 erfolgt.

Danach erfolgt eine Zuschaltung eines vom Testmustergenerator 11 abgeleiteten Eins-Vektors über die Multiplexer 9 und 10 an die V-Eingänge der F-DFFs sowie eine Signaturbildung. Schließlich befinden sich alle F-DFFs im Zustand Eins. Es erfolgt eine Zuschaltung eines Eins-Vektors an die V-Eingänge der F-DFFs über die Multiplexer 9 und 10 und danach eine Signaturbildung. Dies entspricht dem zweiten Teil eines Rückkopplungstests, wobei dieser unter Verwendung der unteren Eingänge des Multiplexers 9 und der oberen Eingänge des Multiplexers 10 erfolgt.

Zum Test der Verdrahtung zwischen den Testgruppen werden alle Ausgangslogiken der restlichen Testgruppen sequentiell zweimal invertiert. Die Verdrahtungssignale werden über die Multiplexer 8 und 10 an die Eingänge V des F-DFFs geschaltet und anschließend erfolgt eine Signaturbildung.

Zum Test der kombinatorische Logik wird beispielsweise ein aus dem 20-Bit-Testmustergenerator 11 abgeleitetes Zufallsmuster über die Multiplexer 8 und 9 an die kombinatorische Logik 6 angelegt. Dies erfolgt über eine Zeitdauer von maximal $2^{20}$-1 Taktsignalen und kann auf mehrere Zeitschlitze aufgeteilt sein. Gleichzeitig erfolgt eine Signaturbildung. Am Ende erfolgt ein Auslesen der Signatur im Schiebemodus über eine Dauer von zehn Taktsignalen mit gleichzeitigem Signaturvergleich.

Die Figur 2 zeigt ein Blockschaltbild einer aus drei F-DFFs bestehenden Speicherkette. Wie aus der Figur ersichtlich ist, sind die Ausgänge der linken beiden Flip-Flops jeweils an den Sh-Eingang und Rückkopplungseingang RK des nachfolgenden F-DFFs angeschlossen. Am Eingang RK des ersten F-DFFs liegt in diesem speziellen Fall ein Signal an, welches einer XOR-Verknüpfung der Ausgangssignale Q0 und Q1 des zweiten und dritten F-DFFs entspricht. Durch eine derartige Verdrahtung von n F-DFFs können beispielsweise im Signaturbildungsmodus die n-Bit-Flip-Flops der Testgruppen als lineares, rückgekoppeltes Schieberegister arbeiten. Dies erlaubt eine Signaturbildung unter Verwendung der Testvektoren.

Die Figur 5 zeigt ein Blockschaltbild eines zweiten Ausführungsbeispiels für die Eingangslogik eines F-DFFs. Bei diesem Ausführungsbeispiel sind statt einem 3:1-Multiplexer zwei 2:1-Multiplexer 2a, 2b vorgesehen. Diese Variante benötigt zwar mehr Hardware, bietet dafür aber kürzere Durchlaufzeiten für die Daten im Normalbetrieb.

Die Figur 6 zeigt ein Blockschaltbild eines dritten Ausführungsbeispiels für die Eingangslogik eines F-DFFs. Dieses Ausführungsbeispiel benötigt weniger Gatter, hat dafür aber längere Durchlaufzeiten und benötigt drei Betriebsartkennsignale.

Vorstehend wurde die Erfindung am Beispiel eines Bausteins bzw. ASICs erläutert. Die Prinzipien der Erfindung können aber auch beim Vorliegen einer Baugruppe angewendet werden. Unter Baugruppe wird in diesem Zusammenhang eine bestückte Leiterplatte verstanden, deren Verdrahtungen getestet werden.

Wie bereits oben ausgeführt wurde, können die Prinzipien der Erfindung sowohl beim Vorliegen einkanaliger als auch beim Vorliegen mehrkanaliger Strukturen verwendet werden. Liegen einkanalige Strukturen vor, dann wird die Steuereinheit für die Funktion Selbstüberwachung erweitert, um auch die Fehlersicherheit der Steuereinheit gewährleisten zu können. Der Selbsttest der Steuereinheit wird regelmäßig in Zeitschlitzen während des Normalbetriebs durchgeführt. Dabei sendet die Steuereinheit als Lebenszeichen in regelmäßigen Intervallen, beispielsweise alle Millisekunden, einen Impuls an eine Bausteinlogik oder an eine Baugruppe. Eine Testgruppe (FSM) der Bausteinlogik oder eine Auswertelogik der Baugruppe überwacht das Lebenszeichen der Steuereinheit und bringt beim Ausfall des Lebenszeichens das System in den sicheren Zustand.

**Patentansprüche**

1. Verfahren zum Betreiben eines Logik- und Speicherelemente aufweisenden Bausteins oder einer Logik- und Speicherelemente aufweisenden Baugruppe, wobei der Baustein oder die Baugruppe in verschiedenen Betriebsarten betreibbar ist, von denen eine der Normalbetrieb und eine weitere ein Testbetrieb ist,
**dadurch gekennzeichnet, dass**

   - die Betriebszeit des Bausteins oder der Baugruppe in Zeitschlitze unterteilt wird,

   - die verschiedenen Betriebsarten im Zeitmultiplex ohne Unterbrechung wiederholt durchgeführt werden, wobei jeder Zeitschlitz einer Betriebsart zugeordnet wird,

   - aus Logik- und/oder Speicherelementen des Bausteins oder der Baugruppe mindestens eine Testgruppe gebildet wird, und

   - die durch den Selbsttest veränderten internen Zustände der Testgruppe(n) am Ende der Testphase aus den zwischengespeicherten Zuständen wiederhergestellt werden.

2. Verfahren nach Anspruch 1, **dadurch gekennzeichnet, dass** der Testbetrieb ein Online-Testbetrieb ist und der Baustein oder die Baugruppe unterbrechungsfrei betrieben wird.

3. Verfahren nach Anspruch 1 oder 2, **dadurch gekennzeichnet, dass** während des Testbetriebes eine Veränderung des Ausgangszustands jeder Testgruppe verhindert wird.

4. Verfahren nach einem der vorhergehenden Ansprüche, **dadurch gekennzeichnet, dass** der Testbetrieb einen Schiebemodus und einen Signaturbildungsmodus aufweist.

5. Verfahren nach einem der vorhergehenden Ansprüche, **dadurch gekennzeichnet, dass** der Testbetrieb weiterhin einen Verdrahtungstestmodus aufweist.

6. Verfahren nach einem der vorhergehenden Ansprüche, **dadurch gekennzeichnet, dass** dem Baustein oder der Baugruppe im Testbetrieb n-Bit breite Testvektoren zugeführt werden, dass unter Verwendung dieser Testvektoren bezüglich der zu testenden Testgruppe eine Signaturbildung erfolgt und dass das Ergebnis der Signaturbildung bitweise mit einer Referenzsignatur verglichen wird.

7. Verfahren nach Anspruch 6, **dadurch gekennzeichnet, dass** die Referenzsignatur von einem identisch aufgebauten, Logik- und Speicherelemente aufweisenden Baustein oder einer identisch aufgebauten, Logik- und Speicherelemente aufweisenden Baugruppe, die mit identischen Testvektoren beaufschlagt wird, abgeleitet wird.

8. Verfahren nach Anspruch 6, **dadurch gekennzeichnet, dass** die Referenzsignatur von einem diversitär aufgebauten, Logik- und Speicherelemente aufweisenden Baustein oder einer diversitär aufgebauten, Logik- und Speicherelemente aufweisenden Baugruppe, die mit eindeutig zuordenbaren Testvektoren beaufschlagt wird, abgeleitet wird.

9. Verfahren nach Anspruch 6, **dadurch gekennzeichnet, dass** die abgelegte Referenzsignatur aus einem internen oder externen Speicher abgeleitet wird.

10. Verfahren nach einem der vorhergehenden Ansprüche, **dadurch gekennzeichnet, dass** die Testintervalle und die Zuordnung zwischen den Zeitschlitzen und den Betriebsarten bei der Herstellung des Bausteins oder der Baugruppe oder am Einsatzort vorgenommen werden.

11. Verfahren nach einem der vorhergehenden Ansprüche, **dadurch gekennzeichnet, dass** während des Betriebes des Bausteins oder der Baugruppe von einer Steuereinheit Betriebsartkennsignale an eine der zu testenden Testgruppe zugeschaltete Testlogik übertragen werden und mittels der Testlogik in Abhängigkeit von den Betriebsartkennsignalen vorgegebene Signale an die Logik- und Speicherelemente der Testgruppe weitergeleitet werden.

12. Verfahren nach einem der vorhergehenden Ansprüche, **dadurch gekennzeichnet, dass** die Teststrukturen auch als Scan-Path-Struktur für den Herstellungtest verwendet werden.

13. In verschiedenen Betriebsarten betreibbarer Baustein, welcher eine Vielzahl von Logik- und Speicherelementen aufweist, wobei die Logik und/oder Speicherelemente mindestens eine Testgruppe bilden, jeder Testgruppe eine zusätzliche Testlogik zugeordnet ist, die Testlogik eine Eingangslogik und eine Ausgangslogik aufweist, die Eingangslogik zum Empfang von Betriebsartkennsignalen, Nutzsignalen und Testsignalen vorgesehen ist, und welche einen Zwischenspeicher aufweist, mittels dessen die durch den Selbsttest veränderten internen Zustände der Testgruppe(n) am Ende der Testphase wiederhergestellt werden.

**14.** Baustein nach Anspruch 13, **dadurch gekennzeichnet, dass** Zustandshaltemittel vorgesehen sind, um während des Testbetriebes eine Veränderung der Ausgangszustände der Testgruppe(n) zu verhindern.

**15.** Baustein nach Anspruch 13 oder 14, **dadurch gekennzeichnet, dass** die Eingangslogik mindestens einen Multiplexer aufweist, der in Abhängigkeit von den Betriebsartkennsignalen umschaltbar ist.

**16.** Baustein nach einem der Ansprüche 13 bis 15, **dadurch gekennzeichnet, dass** das Speicherelement einer Testgruppe ein D-Flip-Flop ist.

**17.** Baustein nach Anspruch 16, **dadurch gekennzeichnet, dass** das D-Flip-Fop an den Ausgang des Multiplexers angeschlossen ist.

**18.** Baustein nach einem der Ansprüche 13 bis 17, **dadurch gekennzeichnet, dass** er einen Testvektorspeicher aufweist.

**19.** Baustein nach Anspruch 18, **dadurch gekennzeichnet, dass** der Testvektorspeicher ein Testmustergenerator ist.

**20.** Baustein nach einem der Ansprüche 13 bis 19, **dadurch gekennzeichnet, dass** er eine interne oder externe Referenzsignaturquelle aufweist.

**21.** Baustein nach einem der Ansprüche 13 bis 20, **dadurch gekennzeichnet, dass** er einen Anschluss zur Ein- und/oder Ausgabe von Signatursignalen aufweist.

**22.** Baustein nach Anspruch 20 oder 21, **dadurch gekennzeichnet, dass** er einen testbaren Vergleicher zur Durchführung eines Signaturvergleiches aufweist.

**Claims**

**1.** Method for operating a device having logic and memory elements or a module having logic and memory elements, said device or module being able to be operated in various modes, one of which is normal mode and another a test mode, **characterised in that**

- the operating time of the device or module is subdivided into time slots,

- the various operating modes can be repeated continuously on a time division multiplex basis, each time slot being assigned to an operating mode,

- at least one test group is formed from logic and/or memory elements of the device or module, and

- at the end of the test phase, the internal states of the test group(s) which have been changed by the self-test are restored from the buffered states.

**2.** Method according to Claim 1, **characterised in that** the test mode is an online test mode and the device or module is continuously operated.

**3.** Method according to Claim 1 or 2, **characterised in that** during test mode any change in the output state of each test group is prevented.

**4.** Method according to one of the preceding Claims, **characterised in that** test mode has a shift mode and a signature forming mode.

**5.** Method according to one of the preceding Claims, **characterised in that** test mode additionally has a wiring test mode.

**6.** Method according to one of the preceding Claims, **characterised in that** n-bit wide test vectors are applied to the device or module during test mode, that signature forming in respect of the test group to be tested takes place using said test vectors, and that the result of the signature forming is compared bit by bit with a reference signature.

**7.** Method according to Claim 6, **characterised in that** the reference signature is derived from a constructionally identical device having logic and memory elements or a constructionally identical module having logic and memory elements, to which identical test vectors are applied.

**8.** Method according to Claim 6, **characterised in that** the reference signature is derived from a constructionally different device having logic and memory elements or a constructionally different module having logic and memory elements, to which uniquely assignable test vectors are applied.

9. Method according to Claim 6, **characterised in that** the stored reference signature is derived from an internal or external memory.

10. Method according to one of the preceding Claims, **characterised in that** the test intervals and the assignment between the time slots and the operating modes are established during manufacture of the device or module or in the field.

11. Method according to one of the preceding Claims, **characterised in that**, during operation of the device or module, operating mode identifying signals are transmitted from a control unit to a test logic connected to one of the test groups to be tested and, by means of said test logic, specified signals are forwarded to the logic and memory elements of said test group depending on the operating mode identifying signals.

12. Method according to one of the preceding Claims, **characterised in that** the test structures can also be used as a scan-path structure for production testing.

13. Device which can be operated in various modes and which has a plurality of logic and memory elements, said logic and/or memory elements forming at least one test group, each test group being assigned an additional test logic, said test logic having an input logic and an output logic, said input logic being provided for receiving operating mode identifying signals, user signals and test signals, and having a buffer memory by means of which the internal states of the test group(s) which have been changed by the self-test are restored at the end of the test phase.

14. Device according to Claim 13, **characterised in that** state-holding means are provided in order to prevent any change in the output states of the test group(s) during test mode.

15. Device according to Claim 13 or 14, **characterised in that** the input logic has at least one multiplexer which can be switched over depending on the operating mode identifying signals.

16. Device according to one of Claims 13 to 15, **characterised in that** the memory element of a test group is a D flip-flop.

17. Device according to Claim 16, **characterised in that** the D flip-flop is connected to the multiplexer output.

18. Device according to one of Claims 13 to 17, **characterised in that** it has a test vector memory.

19. Device according to Claim 18, **characterised in that** the test vector memory is a test pattern generator.

20. Device according to one of Claims 13 to 19, **characterised in that** it has an internal or external reference signature source.

21. Device according to one of Claims 13 to 20, **characterised in that** it has a terminal for signature signal input and/or output.

22. Device according to Claim 20 or 21, **characterised in that** it has a testable comparator for performing a signature comparison.

**Revendications**

1. Procédé pour exploiter un composant comportant des éléments logiques et des éléments mémoires ou un module comportant des éléments logiques et des éléments mémoires, le composant ou le module pouvant être exploité dans différents modes d'exploitation parmi lesquels un mode correspond à l'exploitation normale et un autre mode à une exploitation de test, **caractérisé par le fait que**

   - on divise le temps d'exploitation du composant ou du module en créneaux temporels,
   - on réalise les différents modes d'exploitation de façon répétée et sans interruption en multiplex temporel, chaque créneau temporel étant associé à un mode d'exploitation,
   - on forme au moins un groupe de test à partir des éléments logiques et/ou des éléments mémoires du composant ou du module, et
   - à la fin de la phase de test, on rétablit les états internes, modifiés par le test automatique, du ou des groupes de test à partir des états mémorisés temporairement.

2. Procédé selon la revendication 1, **caractérisé par le fait que** l'exploitation de test est une exploitation de test en ligne et que le composant ou le module est exploité sans interruption.

3. Procédé selon la revendication 1 ou 2, **caractérisé par le fait que**, pendant l'exploitation de test, on empêche une modification de l'état de sortie de chaque groupe de test.

4. Procédé selon l'une des revendications précédentes, **caractérisé par le fait que** l'exploitation de test comporte un mode de décalage et un mode de formation de signature.

5. Procédé selon l'une des revendications précédentes, **caractérisé par le fait que** l'exploitation de test comporte en plus un mode de test de câblage.

6. Procédé selon l'une des revendications précédentes, **caractérisé par le fait que**, pendant l'exploitation de test, on envoie au composant ou au module des vecteurs de test d'une largeur de n bits, on réalise une formation de signature en utilisant ces vecteurs de test pour le groupe de test à tester et on compare bit à bit le résultat de la formation de signature à une signature de référence.

7. Procédé selon la revendication 6, **caractérisé par le fait qu'**on déduit la signature de référence d'un composant comportant des éléments logiques et des éléments mémoires et de structure identique qui est alimenté avec des vecteurs de test identiques ou d'un module comportant des éléments logiques et des éléments mémoires et de structure identique qui est alimenté avec des vecteurs de test identiques.

8. Procédé selon la revendication 6, **caractérisé par le fait qu'**on déduit la signature de référence d'un composant comportant des éléments logiques et des éléments mémoires et de structure différente qui est alimenté avec des vecteurs de test attribuables sans équivoque ou d'un module comportant des éléments logiques et des éléments mémoires et de structure différente qui est alimenté avec des vecteurs de test attribuables sans équivoque.

9. Procédé selon la revendication 6, **caractérisé par le fait qu'**on déduit la signature de référence enregistrée d'une mémoire interne ou externe.

10. Procédé selon l'une des revendications précédentes, **caractérisé par le fait qu'**on met en oeuvre l'intervalle de test et l'association entre les créneaux temporels et les modes d'exploitation lors de la fabrication du composant ou du module ou sur le lieu d'utilisation.

11. Procédé selon l'une des revendications précédentes, **caractérisé par le fait que**, pendant l'exploitation du composant ou du module, une unité de commande transmet des signaux indicateurs de mode d'exploitation à une logique de test adjointe au groupe de test à tester et, au moyen de la logique de test, des signaux prédéterminés en fonction des signaux indicateurs de mode d'exploitation sont retransmis aux éléments logiques et éléments mémoires du groupe de test.

12. Procédé selon l'une des revendications précédentes, **caractérisé par le fait qu'**on utilise aussi les structures de test comme structures d'analyse de chemin Scan-Path pour le test de fabrication.

13. Composant pouvant être exploité dans différents modes d'exploitation et comportant une multiplicité d'éléments logiques et d'éléments mémoires, les éléments logiques et/ou mémoires formant au moins un groupe de test, une logique de test supplémentaire étant associée à chaque groupe de test, la logique de test comportant une logique d'entrée et une logique de sortie, la logique d'entrée étant prévue pour la réception de signaux indicateurs de mode d'exploitation, de signaux utiles et de signaux de test et la logique de test comportant une mémoire intermédiaire au moyen de laquelle les états internes, modifiés par le test automatique, du ou des groupes de test sont rétablis à la fin de la phase de test.

14. Composant selon la revendication 13, **caractérisé par le fait que** des moyens de conservation d'état sont prévus pour empêcher une modification des états de sortie du ou des groupes de test pendant l'exploitation de test.

15. Composant selon la revendication 13 ou 14, **caractérisé par le fait que** la logique d'entrée comporte au moins un multiplexeur qui est commutable en fonction des signaux indicateurs de mode d'exploitation.

16. Composant selon l'une des revendications 13 à 15, **caractérisé par le fait que** l'élément mémoire d'un groupe de test est une bascule bistable D.

17. Composant selon la revendication 16, **caractérisé par le fait que** la bascule bistable D est raccordée à la sortie du multiplexeur.

18. Composant selon l'une des revendications 13 à 17, **caractérisé par le fait qu'**il comporte une mémoire de vecteurs de test.

19. Composant selon la revendication 18, **caractérisé par le fait que** la mémoire de vecteurs de test est un générateur de modèles de test.

20. Composant selon l'une des revendications 13 à 19, **caractérisé par le fait qu'**il comporte une source interne ou externe de signatures de référence.

21. Composant selon l'une des revendications 13 à 20, **caractérisé par le fait qu'**il comporte une connexion pour l'entrée et/ou la sortie de signaux de signatures.

22. Composant selon la revendication 20 ou 21, **carac-**

**térisé par le fait qu'**il comporte un comparateur testable pour la mise en oeuvre d'une comparaison de signatures.

# FIG 1

# FIG 2

## FIG 3

T$_{AUS}$

BKA1, BKA2

20

00
01
11

21

Q

CLK

$\overline{Q}$

22

0
1

A

D

CLK

T

AV

## FIG 4

BK1, BK2

V

3

2

Sh

D

RK

BK2

5

4

1

CLK

A

T

CLK

# FIG 5

# FIG 6